# EUROPÄISCHE PATENTSCHRIFT

(11) **EP 1 915 788 B1**
(45) Veröffentlichungstag und Bekanntmachung des Hinweises auf die Patenterteilung: **15.12.2010**
(21) Anmeldenummer: 06762791.9
(22) Anmeldetag: 25.07.2006
(51) Int. Cl.: H01L 51/00

(54) **LÖSUNGSMITTELGEMISCHE FÜR ORGANISCHE HALBLEITER**
SOLVENT MIXTURES FOR ORGANIC SEMICONDUCTORS
MELANGES DE SOLVANTS POUR SEMI-CONDUCTEURS ORGANIQUES

(30) Priorität: 18.08.2005 DE 102005039528
(43) Veröffentlichungstag der Anmeldung: 30.04.2008
(73) Patentinhaber: Merck Patent GmbH, 64293 Darmstadt (DE)
(72) Erfinder: BECKER, Heinrich, 65719 Hofheim (DE); HEUN, Susanne, 65812 Bad Soden (DE)
(86) Internationale Anmeldenummer: PCT/EP2006/007295
(87) Internationale Veröffentlichungsnummer: WO 2007/019944

(56) Entgegenhaltungen:
- US-A- 5 091 004
- US-A1- 2005 067 949
- US-B1- 6 541 300
- US-B1- 6 878 312

## Beschreibung

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. Die Entwicklung organischer Transistoren (O-TFTs, O-FETs), organischer integrierter Schaltungen (O-ICs), organischer Feld-Quench-Devices (O-FQDs), organischer lichtemittierender Transistoren (O-LFTs), lichtemittierender elektrochemischer Zellen (LECs) und organischer Solarzellen (O-SCs) ist im Forschungsstadium schon sehr weit gediehen, so dass eine Markteinführung innerhalb der nächsten Jahre erwartet werden kann. Bei den organischen Elektrolumineszenzvorrichtungen (OLEDs, PLEDs) ist die Markteinführung bereits erfolgt. Trotz aller Fortschritte sind aber noch deutliche Verbesserungen nötig, um diese Displays zu einer echten Konkurrenz zu den derzeit marktbeherrschenden Flüssigkristallanzeigen (LCDs) zu machen.

Lösungen organischer Halbleitermaterialien, wie z. B. Ladungstransportpolymere und verschiedene lichtemittierende Materialien, können für verschiedene Druckverfahren und Spincoating-Verfahren eingesetzt werden. Derzeit wird wegen der guten Steuerbarkeit, der erreichbaren Auflösung und der großen Variabilität hauptsächlich an Tintenstrahl-Druckverfahren (Ink-Jet Printing, IJP) gearbeitet. Grundsätzlich eignen sich aber auch andere Druckverfahren, wie z. B. Offsetdruck, Transferdruck oder Tiefdruckverfahren. Andererseits können auch entsprechenden Farbdisplays durch photolithographische Verfahren erzeugt werden. Hierbei können dann Flächenbeschichtungsverfahren, beispielsweise Spincoating, verwendet werden, ebenso wie für einfarbige Anzeigevorrichtungen. Für all diese Möglichkeiten benötigt man geeignete Lösungen, die sich einerseits zum Drucken bzw. zum Aufbringen durch Flächenbeschichtungsverfahren eignen, die andererseits aber auch die Eigenschaften der PLEDs nicht verschlechtern.

Es wurde beobachtet, dass Schichten organischer Halbleiter, die an Luft hergestellt wurden, schlechtere elektronische Eigenschaften, insbesondere geringere Effizienz der Lichtemission sowie schlechtere operationelle Stabilität, aufweisen als solche, die unter einer Schutzgasatmosphäre hergestellt wurden. Vermutlich sind die in der Luft anwesenden Spurengase, beispielsweise Ozon, für diese Beobachtung verantwortlich. So zeigt ein Vergleich der maximalen Effizienz verschiedener Polymere bei Exposition mit 50 ppb Ozon, dass durch den Einfluss des Ozons die maximale Effizienz deutlich abnimmt. Daher liegt die Vermutung nahe, dass atmosphärische Spurengase jeder Art negative Auswirkungen auf die elektrooptischen Eigenschaften der Lösungen haben können.

Verfahren zur Herstellung von Schichten organischer Halbleiter, welche nicht unter Schutzgasatmosphäre stattfinden, führen daher zu einer Abnahme der maximalen Effizienz der Lichtemission und damit auch zu schlechteren Displays oder Lichtquellen. Auf der anderen Seite benötigt die Herstellung der Schichten unter einer Schutzgasatmosphäre einen deutlich höheren technischen Aufwand, so dass es sinnvoll wäre, die Schichten an Luft herstellen zu können.

Überraschend wurde nun gefunden, dass die Zugabe mindestens eines Alkens zur Lösung des organischen Halbleitermaterials bei Herstellung der Schichten an Luft zu einer deutlichen Verbesserung der Effizienzen der Materialien führt.

In der WO 01/16251 werden Lösungen organischer Halbleiter beschrieben, wobei das Lösemittel bzw. Lösemittelgemisch mindestens ein Terpen und/oder eine polyalkylierte aromatische Verbindung enthält. In den Beispielen werden dabei Lösemittelmischungen offenbart, die aus polyalkylierten aromatischen Verbindungen und Terpenen im Verhältnis 3 : 1 bestehen. Eine Mischung mit einem derartig hohen Anteil an Terpenen hat den entscheidenden Nachteil, dass viele organische Halbleiter in diesem Lösemittelgemisch nicht löslich sind, so dass die offenbarten Lösemittelmischungen möglicherweise für den dort verwendeten Polymer-Blend geeignet sind, aber nicht für eine Vielzahl anderer organischer Halbleiter.

US 2005/0067949 offenbart Lösemittelgemische zur Abscheidung von organischen Halbleitern.

Gegenstand der vorliegenden Erfindung sind einphasige, flüssige Zusammensetzungen (Lösungen) enthaltend
- mindestens einen organischen Halbleiter,
- mindestens ein organisches Lösemittel für den organischen Halbleiter, und
- mindestens ein aliphatisches oder cyclo-aliphatisches Alken,
die dadurch gekennzeichnet sind, dass der Anteil des Alkens zwischen 0,01 und 20 Gew.-% beträgt, bezogen auf das Lösemittel bzw. Lösemittelgemisch, und dass der Siedepunkt des Alkens größer als 50°C und kleiner als 200°C ist.

Lösungen im Sinne dieses Anmeldungstextes sind flüssige, homogene Mischungen von Festsubstanzen in flüssigen Lösemitteln, in denen die Feststoffe molekulardispers gelöst vorliegen, d. h. die Mehrzahl der Feststoffmoleküle liegt tatsächlich gelöst und nicht in Form von Aggregaten bzw. Nano- oder Mikropartikeln vor.

Unter einem organischen Lösemittel im Sinne der vorliegenden Erfindung sollen organische Stoffe verstanden werden, die andere Stoffe auf physikalischem Wege zur Lösung bringen können, ohne dass sich beim Lösungsvorgang der lösende oder der gelöste Stoff chemisch verändern. Dabei beträgt die Löslichkeit des organischen Halbleiters im organischen Lösemittel bzw. im organischen Lösemittelgemisch bei Raumtemperatur und Normaldruck vorzugsweise mindestens 1 g/l, besonders bevorzugt mindestens 3 g/l, und insbesondere mindestens 5 g/l unter Bildung einer klaren, fließfähigen Lösung.

Im Rahmen der vorliegenden Erfindung beträgt Raumtemperatur 20°C und Normaldruck bedeutet 1013 mbar.

Ein weiterer Gegenstand der vorliegenden Erfindung ist die Verwendung der erfindungsgemäßen Lösungen, um Schichten organischer Halbleiter auf einem Substrat zu erzeugen.

Eine bevorzugte Ausführungsform ist dabei die Verwendung von Druckverfahren zur Herstellung der organischen Halbleiterschichten. Besonders bevorzugt ist dabei die Verwendung von Tintenstrahl-Druckverfahren (IJP).

Eine weitere bevorzugte Ausführungsform ist die Verwendung von Flächenbeschichtungsverfahren zur Herstellung der organischen Halbleiterschichten, insbesondere die Verwendung von Spincoating.

Ebenfalls Gegenstand der vorliegenden Erfindung sind Schichten der organischen Halbleiter, hergestellt unter Verwendung der erfindungsgemäßen Lösungen.

Noch ein weiterer Gegenstand der Erfindung sind organische elektronische Vorrichtungen, bevorzugt organische Feld-Effekt-Transistoren (O-FET), organische Dünnfilmtransistoren (O-TFT), organische integrierte Schaltungen (O-IC), organische Feld-Quench-Devices (O-FQDs), organische lichtemittierende Transistoren (O-LETs), lichtemittierende elektrochemische Zellen (LECs), organische Solarzellen (O-SC) oder organische Laserdioden (O-Laser), insbesondere aber organische und polymere Leuchtdioden (OLED, PLED), enthaltend mindestens eine erfindungsgemäße Schicht.

Schichten der an sich bekannten organischen Halbleiter sind in der Literatur bereits beschrieben. Die aus den erfindungsgemäßen Lösungen an der Luft hergestellten Schichten zeigen gegenüber den bislang beschriebenen Schichten verbesserte elektronische Eigenschaften. Insbesondere erhält man mit den aus den erfindungsgemäßen Lösungen hergestellten Schichten höhere Leuchteffizienzen als gemäß dem Stand der Technik, wenn die Schichten an der Luft hergestellt wurden.

Organische Halbleiter im Sinne dieser Anmeldung sind niedermolekulare, oligomere, dendritische, lineare oder verzweigte sowie insbesondere polymere organische oder metallorganische Verbindungen bzw. Mischungen von Verbindungen, die als Feststoff bzw. als Schicht halbleitende Eigenschaften aufweisen, d. h. bei denen die Energielücke zwischen Leitungs- und Valenzband zwischen 1,0 und 3,5 eV liegt.

Als organischer Halbleiter wird hier entweder eine Reinkomponente oder eine Mischung von zwei oder mehreren Komponenten, von denen mindestens eine halbleitende Eigenschaften aufweisen muss, verwendet. Bei der Verwendung von Mischungen ist es jedoch nicht notwendig, dass jede Komponente halbleitende Eigenschaften aufweist. So können beispielsweise inerte niedermolekulare Verbindungen zusammen mit halbleitenden Polymeren verwendet werden. Ebenso können nicht-leitende Polymere, die als inerte Matrix bzw. Binder dienen, zusammen mit einer oder mehreren niedermolekularen Verbindungen oder weiteren Polymeren, die halbleitende Eigenschaften aufweisen, verwendet werden. Die potenziell beigemischte nicht-leitende Komponente ist im Sinne dieser Anmeldung als eine elektro-optisch nicht wirksame, inerte, passive Verbindung zu verstehen.

Bevorzugt sind Lösungen polymerer organischer Halbleiter, welche eventuell weitere Substanzen eingemischt enthalten. Das Molekulargewicht M_{w} der polymeren organischen Halbleiter ist vorzugsweise größer 10000 g/mol, besonders bevorzugt zwischen 50000 und 1000000 g/mol, und insbesondere zwischen 100000 und 500000 g/mol. Als polymere organische Halbleiter im Sinne der vorliegenden Erfindung werden insbesondere
(i) die in EP 0443861, WO 94/20589, WO 98/27136, EP 1025183, WO 99/24526, DE 19953806 und EP 0964045 offenbarten, in organischen Lösemitteln löslichen, substituierten Poly-p-arylen-vinylene (PAVs),
(ii) die in EP 0842208, WO 00/22027, WO 00/22026, DE 19846767, WO 00/46321, WO 99/54385 und WO 00/55927 offenbarten, in organischen Lösemitteln löslichen, substituierten Polyfluorene (PFs),
(iii) die in EP 0707020, WO 96/17036, WO 97/20877, WO 97/31048, WO 97/39045 und WO 03/020790 offenbarten, in organischen Lösemitteln löslichen, substituierten Poly-spirobifluorene (PSFs),
(iv) die in WO 92/18552, WO 95/07955, EP 0690086, EP 0699699 und WO 03/099901 offenbarten, in organischen Lösemitteln löslichen, substituierten Poly-paraphenylene (PPPs) oder -biphenylene,
(v) die in WO 05/014689 offenbarten, in organischen Lösemitteln löslichen, substituierten Poly-dihydrophenanthrene (PDHPs),
(vi) die in WO 04/041901 und WO 04/113412 offenbarten, in organischen Lösemitteln löslichen, substituierten Poly-trans-indenofluorene und Poly-cis-indenofluorene (PIF),
(vii) die in der nicht offengelegten Anmeldung DE 102004020298.2 offenbarten, in organischen Lösemitteln löslichen, substituierten Poly-phenanthrene,
(viii) die in EP 1028136 und WO 95/05937 offenbarten, in organischen Lösemitteln löslichen, substituierten Polythiophene (PTs),
(ix) die in T. Yamamoto et al., J. Am. Chem. Soc. 1994, 116, 4832 offenbarten, in organischen Lösemitteln löslichen Polypyridine (PPys),
(x) die in V. Gelling et al., Polym. Prepr. 2000, 41, 1770 offenbarten, in organischen Lösemitteln löslichen Polypyrrole,
(xi) substituierte, lösliche Copolymere, die Struktureinheiten aus zwei oder mehr der Klassen (i) bis (x) aufweisen, wie zum Beispiel in WO 02/077060 beschrieben,
(xii) die in Proc. of ICSM '98, Part I & II (in: Synth. Met. 1999, 101/102*)* offenbarten, in organischen Lösemitteln löslichen konjugierten Polymere,
(xiii) substituierte und unsubstituierte Poly-vinyl-carbazole (PVKs), wie beispielsweise in R. C. Penwell et al., J. Polym. Sci., Macromol. Rev. 1978, 13, 63-160 offenbart,
(xiv) substituierte und unsubstituierte Triarylaminpolymere, wie beispielsweise in JP 2000/072722 offenbart,
(xv) substituierte und unsubstituierte Polysilylene und Polygermylene, wie beispielsweise in M. A. Abkowitz and M. Stolka, Synth. Met. 1996, 78, 333 offenbart, und
(xvi) lösliche Polymere, welche phosphoreszierende Einheiten enthalten, wie beispielsweise in EP 1245659, WO 03/001616, WO 03/018653, WO 03/022908, WO 03/080687, EP 1311138, WO 03/102109, WO 04/003105, WO 04/015025, DE 102004032527.8 und einigen der oben bereits zitierten Schriften offenbart, verstanden.

Des Weiteren bevorzugt sind auch Lösungen von nicht-leitenden, elektronisch inerten Polymeren (Matrix-Polymere), welche niedermolekulare, oligomere, dendritische, lineare oder verzweigte und/oder polymere organische und/oder metallorganische Halbleiter eingemischt enthalten.

Die Lösungen können weitere Additive, die z.B. die Benetzungseigenschaften verändern können, enthalten. Derartige Additive sind beispielsweise in WO 03/019693 beschrieben.

Die erfindungsgemäßen Lösungen enthalten zwischen 0,01 und 20 Gew.-%, vorzugsweise zwischen 0,1 und 15 Gew.-%, besonders bevorzugt zwischen 0,2 und 10 Gew.-%, und insbesondere zwischen 0,25 und 5 Gew.-% des organischen Halbleiters bzw. des entsprechenden Blends. Die Prozentangaben beziehen sich auf 100 % des Lösemittels bzw. Lösemittelgemischs.

Die Viskosität der erfindungsgemäßen Lösungen ist variabel. Allerdings verlangen gewisse Beschichtungstechniken eine Verwendung gewisser Viskositätsbereiche. So ist in der Regel für die Beschichtung durch IJP ein Bereich von ca. 4 bis 25 mPa·s vorteilhaft. Für Flächenbeschichtungen (wie Spincoating) können Viskositäten im Bereich von ca. 5 bis 40 mPa·s vorteilhaft sein. Für andere Druckverfahren, z. B. Tiefdruckverfahren oder Siebdruck, kann aber auch eine deutlich höhere Viskosität, beispielsweise im Bereich von 20 bis 500 mPa·s, durchaus Vorteile ergeben. Die Einstellung der Viskosität kann durch die Wahl des geeigneten Molekulargewichtsbereiches des organischen Halbleiters bzw. MatrixPolymers sowie durch Wahl eines geeigneten Konzentrationsbereichs und Wahl der Lösemittel erfolgen.

Die Oberflächenspannung der erfindungsgemäßen Lösungen ist zunächst nicht eingeschränkt. Durch die Verwendung entsprechender Lösemittelgemische wird diese vorzugsweise im Bereich von 20 bis 60 dyn/cm (1 dyn=10⁻⁵N) besonders bevorzugt im Bereich von 25 bis 50 dyn/cm, und insbesondere im Bereich von 25 bis 40 dyn/cm liegen.

Als bevorzugte Lösemittel bieten sich einfach oder mehrfach substituierte aromatische Lösemittel, insbesondere substituierte Benzole, Naphthaline, Biphenyle und Pyridine, an. Bevorzugte Substituenten sind Alkylgruppen, die auch fluoriert sein können, Halogenatome, vorzugsweise Chlor und Fluor, Cyanogruppen, Alkoxygruppen, Dialkylaminogruppen, vorzugsweise solche mit nicht mehr als 4 C-Atomen, oder auch Estergruppierungen. Besonders bevorzugte Substituenten sind Fluor, Chlor, Cyano, Methoxy, Ethoxy, Methyl, Ethyl, Propyl, Isopropyl, Trifluormethyl, Methylcarboxylat und/oder Ethylcarboxylat, wobei auch mehrere unterschiedliche Substituenten vorhanden sein können, welche untereinander wiederum einen oder mehrere Ringe bilden können. Aber auch nicht-aromatische Lösemittel, wie beispielsweise Ameisensäurederivate, N-Alkyl-Pyrrolidone oder hochsiedende Ether, kommen als Lösemittel in Frage.

Besonders bevorzugt sind erfindungsgemäße Lösungen, enthaltend als Lösemittel ein oder mehrere Lösemittel ausgewählt aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methyl-anisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, Morpholin, 1,2-Dihydronaphthalin, 1,2,3,4-Tetrahydronaphthalin, 3,4-Dimethylanisol, o-Tolunitril, Veratrol, Ethylbenzoat, N,N-Diethylanilin, Propylbenzoat, 1-Methylnaphthalin, Butylbenzoat, 2-Methylbiphenyl, 2-Phenylpyridin und 2,2'-Bitolyl.

Es kommen auch Mischungen der oben genannten Lösemittel mit Lösemitteln, in denen der organische Halbleiter schlecht löslich ist, in Frage, wie beschrieben in DE 102004023276.8, wie z. B. (cyclo)aliphatische Alkoholen, geradkettigen, verzweigten oder cyclischen Alkanen, vorzugsweise mit mehr als fünf C-Atomen, Ethern, Ketonen, Carbonsäureestern oder einfach oder mehrfach substituierten aromatischen Lösemitteln, insbesondere substituierten Benzolen, Naphthalinen und Pyridinen, die mit langen Alkyl- oder Alkoxysubstituenten substituiert sind.

Weiterhin besonders geeignet sind Mischungen mehrerer Lösemittel, die den organischen Halbleiter unterschiedlich gut lösen und die bestimmte Bedingungen für die jeweiligen Siedepunkte der Lösemittel aufweisen, wie z. B. in DE 102004007777.0 beschrieben.

Die oben aufgeführten Lösemittel können keinen Anspruch auf Vollständigkeit erheben. Die Bereitung einer erfindungsgemäßen Lösung ist dem Fachmann ohne weiteres auch mit anderen hier nicht explizit aufgeführten Lösemitteln ohne erfinderisches Zutun möglich.

Die erfindungsgemäßen Lösungen enthalten - wie oben beschrieben - mindestens einen organischen Halbleiter, mindestens ein Lösemittel für den organischen Halbleiter und mindestens ein Alken, sowie evtl. weitere Additive.

Die erfindungsgemäßen Lösungen enthalten in der Lösung zwischen 0,01 und 20 Gew.-% eines geeigneten Alkens, vorzugsweise zwischen 0,1 und 10 Gew.-%, besonders bevorzugt zwischen 0,5 und 5 Gew.-% des Alkens bzw. einer Mischung aus zwei oder mehreren Alkenen. Dabei bezieht sich der Anteil des Alkens auf 100% des Lösemittels bzw. Lösemittelgemischs.

Der Siedepunkt der Alkene ist kleiner als 200°C, zu wählen. Bei höher siedenden Alkenen sind diese nach Filmbildung nur schwierig und unter hohem technischem Aufwand vollständig zu entfernen.

Die Untergrenze des Siedepunkts der Alkene ist größer als 50°C zu wählen. Ein tieferer Siedepunkt macht eine reproduzierbare Herstellung der Lösungen bzw. der Schichten schwierig, da dann das Alken zu flüchtig ist.

Als zugesetztes Alken eignen sich cyclo-aliphatische und aliphatische Alkene. Diese können jeweils eine oder mehrere Doppelbindungen aufweisen.

Die zugesetzten Alkene sind bei Raumtemperatur vorzugsweise flüssig und enthalten vorzugsweise 5 bis 15 Kohlenstoffatome.

Es wird vermutet, dass die zugesetzten Alkene mit den Spurengasen aus der Luft, insbesondere mit Ozon, reagieren und diese so abfangen und an schädlichen Reaktionen mit dem organischen Halbleiter hindern. Daher werden die Alkene vorzugsweise so ausgewählt, dass deren Reaktionsprodukte nach der Reaktion mit Ozon, also insbesondere die korrespondierenden Aldehyde, flüchtig sind und vorzugsweise 1 bis 10 Kohlenstoffatome enthalten.

Eine Auswahl bevorzugter Alkene als Bestandteil der erfindungsgemäßen Lösungen findet sich in der folgenden Tabelle 1.

**Tabelle 1: Bevorzugte Alkene zur Bereitung erfindungsgemäßer Lösungen**

| **Alken** | **CAS-Nummer** | **Siedepunkt [°C]** |
|---|---|---|
| 2,3-Dimethyl-2-buten | 563-79-1 | |
| 4-Methyl-1-penten | 691-37-2 | 53-54 |
| 2,3-Dimethyl-1-buten | 563-78-0 | 56 |
| 1,5-Hexadien | 592-42-7 | 60 |
| 1-Hexen | 592-41-6 | 62-64 |
| 1-Methyl-1-cyclopenten | 693-89-0 | 72 |
| 1,3-Cyclohexadien | 592-57-4 | 80 |
| Cyclohexen | 110-83-8 | 83 |
| Trans,trans-2,4-hexadien | 592-45-0 | 83 |
| 1,4-Cyclohexadien | 628-41-1 | 88-89 |
| 2-Methyl-1-hexen | 6092-02-6 | 91 |
| 1-Hepten | 592-76-7 | 94 |
| 2,4,4-Trimethyl-1-penten | 107-39-1 | 98-105 |
| 1,7-Octadien | 3710-30-3 | 116-118 |
| 1-Octen | 111-66-0 | 121 |
| Trans-4-octen | 14850-23-8 | 122 |
| Trans-2-Octen | 13389-42-9 | 122-123 |
| 2,5-Dimethyl-2,4-hexadien | 764-13-6 | 134 |
| 1,3-Cyclooctadien | 1700-10-3 | 142-144 |
| Styrol | 100-42-5 | 145-146 |
| Dicyclopentadien | 77-73-6 | 166 |
| 1,9-Decadien | 1647-16-1 | 169 |
| 1-Decen | 872-05-9 | 169-171 |
| 1-Dodecen | 112-41-4 | 213-216 |
| Cyclododecen | 1501-82-2 | |
| 1-Tridecen | 2437-56-1 | 232-233 |
| Cis, trans,trans-1,5,9-Cyclododecatrien | 706-31-0 | 239-241 |

Bevorzugte Alkene sind also 2,3-Dimethyl-2-buten, 4-Methyl-1-penten, 2,3-Dimethyl-1-buten, 1,5-Hexadien, 1-Hexen, 1-Methyl-1-cyclopenten, 1,3-Cyclohexadien, Cyclohexen, Trans,trans-2,4-hexadien , 1,4-Cyclohexadien, 2-Methyl-1-hexen, 1-Hepten, 2,4,4-Trimethyl-1-penten, 1,7-Octadien, 1-Octen, Trans-4-octen, Trans-2-Octen, 1,3-Cyclooctadien, Styrol, Dicyclopentadien, 1,9-Decadien, 1-Decan, 1-Dodecan, Cyclododecen, 2,5-Dimethyl-2,4-hexadien, 1-Tridecen und Cis,trans,trans--1,5,9-Cyclododecatrien.

Diese aufgeführten Alkene können keinen Anspruch auf Vollständigkeit erheben. Die Bereitung einer erfindungsgemäßen Lösung ist dem Fachmann ohne weiteres auch mit anderen hier nicht explizit aufgeführten Alkenen ohne erfinderisches Zutun möglich.

Es kann auch sinnvoll sein, eine Mischung aus mehreren Alkenen zu verwenden. So kann es durchaus sinnvoll und bevorzugt sein, jeweils zwei oder mehrere Alkene zu verwenden, da dadurch teilweise die Optimierung der Lösungseigenschaften einfacher erreicht werden kann, verglichen mit dem Fall, wo nur ein Alken verwendet wird.

Des Weiteren kann es auch sinnvoll sein, neben dem organischen Halbleiter bzw. Blend noch weitere Additive, wie z. B. in der WO 03/019693 beschrieben, zuzusetzen.

Zum Herstellen der Lösungen wird der organische Halbleiter bzw. Blend in der gewünschten Konzentration in dem gewünschten Lösemittel oder Lösemittelgemisch zusammen mit dem gewünschten Alken oder der Alkenmischung gelöst. Es kann sinnvoll sein, den Lösevorgang beispielsweise durch Erhitzen und/oder Rühren zu beschleunigen. Aggregate des organischen Halbleiters bzw. des Matrixpolymers können dabei auch beispielsweise durch äußere mechanische Einwirkung, zum Beispiel durch Ultraschall, wie beschrieben in der WO 03/019694, zerkleinert werden. Weiterhin kann es sinnvoll sein, den organischen Halbleiter bzw. Blend zuerst in dem gewünschten Lösemittel oder Lösemittelgemisch zu lösen und das Alken erst danach zuzusetzen. Ebenso kann es sich weiterhin als sinnvoll erweisen, vor Anwendung der Lösungen diese zu filtrieren, um sie beispielsweise von kleineren Mengen vernetzter Bestandteile und/oder von Staubpartikeln zu reinigen. Vorzugsweise werden die Lösungen unter einer Schutzgasatmosphäre, insbesondere unter Stickstoff oder Argon, zubereitet, jedoch führt auch hier der Alkenzusatz bereits zu einer geringeren Luftempfindlichkeit der Lösungen.

Soll die Herstellung von Elektrolumineszenzvorrichtungen dann doch an Luft erfolgen, bieten die erfindungsgemäßen Lösungen große Vorteile. Es wurde gefunden, dass Elektrolumineszenzvorrichtungen, die aus den erfindungsgemäßen Lösungen an Luft hergestellt wurden, in der Elektrolumineszenz bessere Ergebnisse zeigen, insbesondere eine höhere Effizienz, als solche, die aus Lösungen gemäß dem Stand der Technik an Luft hergestellt wurden. Dies ist ein überraschendes und unerwartetes Ergebnis. Solche Lösungen sind also besser geeignet als Lösungen gemäß dem Stand der Technik, um effiziente Elektrolumineszenzvorrichtungen an Luft herzustellen. Der technische Aufwand zur Herstellung dieser Elektrolumineszenzvorrichtungen ist damit deutlich geringer als gemäß dem Stand der Technik, wo für hohe Effizienz die Verarbeitung dieser Lösungen unter einer Schutzgasatmosphäre notwendig ist.

Im vorliegenden Anmeldetext wird vor allem auf erfindungsgemäße Lösungen zur Herstellung polymerer Leuchtdioden und die entsprechenden Displays abgezielt. Trotz dieser Beschränkung der Beschreibung ist es für den Fachmann ohne weiteres erfinderisches Zutun möglich, entsprechende erfindungsgemäße Lösungen auch für die Herstellung anderer Devices (Vorrichtungen) anzuwenden, z. B. für organische Feld-Effekt-Transistoren (O-FETs), organische Dünnfilmtransistoren (O-TFTs), organische integrierte Schaltungen (O-ICs), organische Feld-Quench-Devices (O-FQDs), organische lichtemittierende Transistoren (O-LFTs), lichtemittierende elektrochemische Zellen (LECs), organische Solarzellen (O-SCs), organische Laserdioden (O-Laser) oder organische Photorezeptoren (O-PCs), um nur einige Anwendungen zu nennen.

Die Erfindung wird im folgenden anhand von Ausführungsbeispielen näher beschrieben, ohne dadurch jedoch beschränkt zu werden.

### Beispiele 1 bis 19

Als Polymere werden ein "Blaues" Copolymer bestehend aus:
50 mol% 2',3',6',7'-Tetra(2-methylbutyloxy)spirobifluoren-2,7-bisboronsäureethylenglycolester), 30 mol% 2,7-Dibromo-2',3',6',7'-tetra(2-methylbutyloxy)spirobifluoren), 10 mol% N,N'-Bis(4-bromphenyl)-N,N'-bis(4-tert-butylphenyl)-benzidin und 10 mol% 2,3,6,7-Tetra-(2-methylbutyloxy)-2',7'-(4-bromstyryl)-9,9'-spirobifluoren (**P1**, siehe auch WO 03/020790),
   sowie ein "Weisses" Copolymer bestehend aus:
50 mol% 2',3',6',7'-Tetra(2-methylbutyloxy)spirobifluoren-2,7-bisboronsäureethylenglycolester), 29,94 mol% 2,7-Dibromo-2',3',6',7'-tetra(2-methylbutyloxy)spirobifluoren), 10 mol% N,N'-Bis(4-bromphenyl)-N,N'-bis(4-tert-butylphenyl)-benzidin und 10 mol% 2,3,6,7-Tetra-(2-methylbutyloxy)-2',7'-(4-bromstyryl)-9,9'-spirobifluoren, 0,05 mol% 1-(2-Ethylhexyloxy)-4-methoxy-2,5-bis-(4-brom-2,5-dimethoxystyryl)-benzol und 0,01 mol% Bis-4,7-(2'-brom-5'-thienyl)-2,1,3-benzothiadiazol (**P2**, siehe auch WO 05/030827) verwendet. Diese werden durch Suzuki-Polymerisation hergestellt, wie in der WO 03/048225 beschrieben und weisen ein Molekulargewicht MW von etwa 500.000 g/mol auf (ermittelt durch GPC).

Weiterhin wird ein "Gelbes" PPV aus 50 mol% 2,5-Bis(chlormethyl)-3'-(3,7-dimethyloctyloxy)biphenyl und 50 mol% 2,5-Bis(chlormethyl)-4-methoxy-3',4'-bis(2-methylpropyloxy)biphenyl verwendet (**P3**). Die Herstellung dieses Polymers und seine weiteren Eigenschaften sind in der WO 99/24526 beschrieben.

Zur Messung der Ozonempfindlichkeit werden Bauteile unter vier verschiedenen Bedingungen hergestellt.
1. Unter Schutzgas in einer Glovebox unter Verwendung von Toluol als Lösungsmittel.
2. Unter Schutzgas in einer Glovebox unter Verwendung von Toluol und Alken-Additiv als Lösungsmittel.
3. Unter einer mittels eines Ozongenerators hergestellten Atmosphäre von 200 ppb Ozon in Luft unter Verwendung von Toluol als Lösungsmittel.
4. Unter einer mittels eines Ozongenerators hergestellten Atmosphäre von 200 ppb Ozon in Luft unter Verwendung von Toluol und Alken-Additiv als Lösungsmittel.

Die Ozonkonzentration wird mittels eines Ozonmessgerätes (Anseros-LUM) bestimmt.

Die Schichten werden für einen Einsatz in PLEDs untersucht. Die PLEDs sind jeweils Zweischichtsysteme, d. h.
Substrat//ITO//PEDOT//Polymer//Kathode. PEDOT ist ein Polythiophen-Derivat (Baytron P, von H. C. Starck, Goslar). Als Kathode wird in allen Fällen Ba/Ag (Aldrich) verwendet. Wie PLEDs dargestellt werden können, ist in der WO 04/037887 und der darin zitierten Literatur ausführlich beschrieben. Die elektrooptische Charakterisierung sowie die Bestimmung der operativen Lebensdauer erfolgt ebenfalls wie in der WO 04/037887 beschrieben.

**Tabelle 1: Eigenschaften der verschiedenen Polymer-Formulierungen**

| **Beispiel** | **Polymer** | Bedingung | Additiv^{a} | max. Eff.^{b} [cd/A] | U^{c} | CIE-Koordinaten^{d} | Lebensdauer^{e} |
|---|---|---|---|---|---|---|---|
| **1** | **P1** | 1 | - | 4,0 | 4,2 | 0,18/0,26 | 2100 |
| **2** | **P1** | 2 | 10 % 1-Hexen | 4,1 | 4,1 | 0,18/0,26 | 2250 |
| **3** | **P1** | 2 | 10% Methylcyclohexen | 4,2 | 4,1 | 0,18/0,27 | 2350 |
| **4** | **P1** | 3 | - | 0,7 | 9,2 | 0,18/0,27 | <10 h |
| **5** | **P1** | 4 | 10 % 1 Hexen | 3,9 | 4,2 | 0,18/0,26 | 1800 |
| **6** | **P1** | 4 | 10% Methylcyclohexen | 4,3 | 4,0 | 0,18/0,27 | 2500 |
| **7** | **P2** | 1 | - | 7,85 | 4,1 | 0,37/0,42 | 1400 |
| **8** | **P2** | 2 | 10% Methylcyclohexen | 8,0 | 4,0 | 0,37/0,41 | 1500 |
| **9** | **P2** | 3 | - | 2,7 | 5,8 | 0,37/0,44 | 120 |
| **10** | **P2** | 4 | 10% Methylcyclohexen | 7,6 | 4,2 | 0,37/0,41 | 1400 |
| **11** | **P3** | 1 | - | 9,1 | 3,1 | 0,51/0,49 | 1100 |
| **12** | **P3** | 2 | 10 % 1-Hexen | 9,3 | 3,1 | 0,51/0,49 | 1200 |
| **13** | **P3** | 3 | - | 2,3 | 6,3 | 0,50/0,50 | 45 |
| **14** | **P3** | 4 | 1% 1-Hexen | 8,0 | 3,8 | 0,51/0,49 | 700 |
| **15** | **P3** | 4 | 5% 1-Hexen | 8,9 | 3,2 | 0,51/0,49 | 1100 |
| **16** | **P3** | 4 | 10% 1-Hexen | 9,2 | 3,1 | 0,51/0,49 | 1350 |
| **17** | **P3** | 4 | 20% 1-Hexen | 8,5 | 3,3 | 0,51/0,49 | 1000 |
| **18** | **P3** | 4 | 10% Methylcyclohexen | 9,5 | 2,9 | 0,51/0,49 | 1300 |
| **19** | **P3** | 4 | 10% 3-Hexen | 8,8 | 3,3 | 0,51/0,49 | 950 |

| | | | | | | | |
|---|---|---|---|---|---|---|---|
| ^{a} vol% ^{b} max. Eff.: Maximale Effizienz, gemessen in cd/A. ^{c} Spannung bei einer Helligkeit von 100 cd/m². ^{d} CIE-Koordinaten: Farbkoordinaten der Commision Internationale de l'Eclairage 1931. ^{e} Lebensdauer: Zeit bis zum Abfall der Helligkeit auf 50 % der Anfangshelligkeit (extrapoliert auf eine Anfangshelligkeit von 100 cd/m², im Fall von P3 auf 1000Cd/m²). | | | | | | | |

## Patentansprüche

1. Einphasige, flüssige Zusammensetzungen (Lösungen) enthaltend
• mindestens einen organischen Halbleiter,
• mindestens ein organisches Lösemittel für den organischen Halbleiter, und
• mindestens ein aliphatisches oder cyclo-aliphatisches Alken,
**dadurch gekennzeichnet, dass** der Anteil des Alkens zwischen 0,01 und 20 Gew.-% beträgt, bezogen auf das Lösemittel bzw. Lösemittelgemisch,
dass der Siedepunkt des Alkens größer als 50°C ist, und
dass der Siedepunkt des Alkens kleiner als 200°C ist.

2. Lösungen nach Anspruch 1, **dadurch gekennzeichnet, dass** der organische Halbleiter eine Reinkomponente oder eine Mischung (Blend) aus zwei oder mehreren Komponenten ist, von denen mindestens eine halbleitende Eigenschaften aufweist.

3. Lösungen nach Anspruch 1 oder 2, **dadurch gekennzeichnet, dass** der organische Halbleiter eine niedermolekulare, oligomere, dendritische, lineare oder verzweigte sowie insbesondere polymere organische oder metallorganische Verbindung bzw. Mischung von Verbindungen ist.

4. Lösungen nach einem oder mehreren der Ansprüche 1 bis 3,
**dadurch gekennzeichnet, dass** mindestens eine Komponente des organischen Halbleiters hochmolekular ist und ein Molekulargewicht M_{w} von größer 10000 g/mol aufweist.

5. Lösungen nach einem oder mehreren der Ansprüche 1 bis 4,
**dadurch gekennzeichnet, dass** polymere organische Halbleiter ausgewählt werden aus den Klassen der in organischen Lösemitteln löslichen substituierten Poly-p-arylen-vinylene (PAVs), Polyfluorene (PFs), Poly-spirobifluorene (PSFs), Poly-p-phenylene (PPPs) oder - biphenylene, Poly-dihydrophenanthrene (PDHPs), trans- und cis-Poly-indenofluorene (PIF), Poly-phenanthrene, Polythiophene (PTs), Polypyridine (PPys), Polypyrrole, Copolymere, die Struktureinheiten aus zwei oder mehr dieser Klassen aufweisen, Poly-vinyl-carbazole (PVKs), Triarylaminpolymere, Polysilylene, Polygermylene und/oder Polymere mit phosphoreszierenden Einheiten.

6. Lösungen nach einem oder mehreren der Ansprüche 1 bis 5, **dadurch gekennzeichnet, dass** die Lösungen zwischen 0,01 und 20 Gew.-% des organischen Halbleiters bzw. des entsprechenden Blends enthalten.

7. Lösungen nach einem oder mehreren der Ansprüche 1 bis 6,
**dadurch gekennzeichnet, dass** als Lösemittel einfach oder mehrfach substituierte aromatische Lösemittel, Ameisensäurederivate, N-Alkyl-Pyrrolidone oder hochsiedende Ether und/oder Mischungen mit geradkettigen, verzweigten oder cyclischen Alkanen, (cyclo)aliphatische Alkoholen, Ethern, Ketonen oder Carbonsäureestern verwendet werden.

8. Lösungen nach einem oder mehreren der Ansprüche 1 bis 7,
**dadurch gekennzeichnet, dass** die Alkene 5 bis 15 Kohlenstoffatome enthalten.

9. Lösungen nach einem oder mehreren der Ansprüche 1 bis 8,
**dadurch gekennzeichnet, dass** die Alkene ausgewählt sind aus 2,3-Dimethyl-2-buten, 4-Methyl-1-penten, 2,3-Dimethyl-1-buten, 1,5-Hexadien, 1-Hexen, 1-Methyl-1-cyclopenten, 1,3-Cyclohexadien, Cyclohexen, Trans,trans-2,4-hexadien, 1,4-Cyclohexadien, 2-Methyl-1-hexen, 1-Hepten, 2,4,4-Trimethyl-1-penten, 1,7-Octadien, 1-Octen, Trans-4-octen, Trans-2-Octen, 1,3-Cyclooctadien, Styrol, Dicyclopentadien, 1,9-Decadien, 1-Decen, 1-Dodecen, Cyclododecen, 2,5-Dimethyl-2,4-hexadien 1-Tridecen und Cis,trans,trans-1,5,9-Cyclododecatrien.

10. Verwendung von Lösungen nach einem oder mehreren der Ansprüche 1 bis 9 zur Erzeugung von Schichten der organischen Halbleiter auf einem Substrat.

11. Verwendung von Lösungen nach Anspruch 10 zur Erzeugung von Schichten der organischen Halbleiter in organischen oder polymeren Leuchtdioden (OLED, PLED), organischen Feld-Effekt-Transistoren (O-FET), organischen Dünnfilmtransistoren (O-TFT), organischen integrierten Schaltungen (O-IC), organischen Feld-Quench-Devices (O-FQDs), organischen lichtemittierenden Transistoren (O-LFTs), lichtemittierenden elektrochemischen Zellen (LECs), organischen Solarzellen (O-SC), organischen Laserdioden (O-Laser) oder organischen Photorezeptoren (O-PC).

12. Verfahren zur Herstellung organischer Halbleiterschichten auf einem Substrat, **dadurch gekennzeichnet, dass** eine Lösung nach einem oder mehreren der Ansprüche 1 bis 9 mittels eines Druckverfahrens oder eines Flächenbeschichtungsverfahrens verarbeitet wird.

## Claims

1. Single-phase, liquid compositions (solutions) comprising
• at least one organic semiconductor,
• at least one organic solvent for the organic semiconductor, and
• at least one aliphatic or cycloaliphatic alkene,
**characterised in that** the proportion of the alkene is between 0.01 and 20% by weight, based on the solvent or solvent mixture,
**in that** the boiling point of the alkene is greater than 50°C, and
**in that** the boiling point of the alkene is less than 200°C.

2. Solutions according to Claim 1, **characterised in that** the organic semiconductor is a pure component or a mixture (blend) of two or more components, at least one of which has semiconducting properties.

3. Solutions according to Claim 1 or 2, **characterised in that** the organic semiconductor is a low-molecular-weight, oligomeric, dendritic, linear or branched and in particular polymeric, organic or organometallic compound or mixture of compounds.

4. Solutions according to one or more of Claims 1 to 3, **characterised in that** at least one component of the organic semiconductor is of high molecular weight and has a molecular weight M_{w} of greater than 10,000 g/mol.

5. Solutions according to one or more of Claims 1 to 4, **characterised in that** polymeric organic semiconductors are selected from the classes of the substituted poly-p-arylenevinylenes (PAVs), polyfluorenes (PFs), polyspirobifluorenes (PSFs), poly-p-phenylenes (PPPs) or -biphenylenes, polydihydrophenanthrenes (PDHPs), trans- and cis-polyindenofluorenes (PIFs), polyphenanthrenes, polythiophenes (PTs), polypyridines (PPys), polypyrroles, copolymers having structural units from two or more of these classes, polyvinylcarbazoles (PVKs), triarylamine polymers, polysilylenes, polygermylenes and/or polymers containing phosphorescent units, all of which are soluble in organic solvents.

6. Solutions according to one or more of Claims 1 to 5, **characterised in that** the solutions comprise between 0.01 and 20% by weight of the organic semiconductor or the corresponding blend.

7. Solutions according to one or more of Claims 1 to 6, **characterised in that** the solvents used are mono- or polysubstituted aromatic solvents, formic acid derivatives, N-alkylpyrrolidones or high-boiling ethers and/or mixtures with straight-chain, branched or cyclic alkanes, (cyclo)aliphatic alcohols, ethers, ketones or carboxylic acid esters.

8. Solutions according to one or more of Claims 1 to 7, **characterised in that** the alkenes contain 5 to 15 carbon atoms.

9. Solutions according to one or more of Claims 1 to 8, **characterised in that** the alkenes are selected from 2,3-dimethyl-2-butene, 4-methyl-1-pentene, 2,3-dimethyl-1-butene, 1,5-hexadiene, 1-hexene, 1-methyl-1-cyclopentene, 1,3-cyclohexadiene, cyclohexene, trans,trans-2,4-hexadiene, 1,4-cyclohexadiene, 2-methyl-1-hexene, 1-heptene, 2,4,4-trimethyl-1-pentene, 1,7-octadiene, 1-octene, trans-4-octene, trans-2-octene, 1,3-cyclooctadiene, styrene, dicyclopentadiene, 1,9-decadiene, 1-decene, 1-dodecene, cyclododecene, 2,5-dimethyl-2,4-hexadiene, 1-tridecene and cis,trans,trans-1,5,9-cyclododecatriene.

10. Use of solutions according to one or more of Claims 1 to 9 for the production of layers of the organic semiconductors on a substrate.

11. Use of solutions according to Claim 10 for the production of layers of the organic semiconductors in organic or polymeric light-emitting diodes (OLEDs, PLEDs), organic field-effect transistors (O-FETs), organic thin-film transistors (O-TFTs), organic integrated circuits (O-ICs), organic field-quench devices (O-FQDs), organic light-emitting transistors (O-LETs), light-emitting electrochemical cells (LECs), organic solar cells (O-SCs), organic laser diodes (O-lasers) or organic photoreceptors (O-PCs).

12. Process for the production of organic semiconductor layers on a substrate, **characterised in that** a solution according to one or more of Claims 1 to 9 is processed by means of a printing process or an area-coating process.

## Revendications

1. Compositions liquides (solutions) monophases comprenant :
• au moins un semiconducteur organique,
• au moins un solvant organique pour le semiconducteur organique, et
• au moins un alcène aliphatique ou cycloaliphatique,
**caractérisées en ce que** la proportion de l'alcène est entre 0,01 et 20% en poids, sur la base du solvant ou du mélange de solvant,
**en ce que** le point d'ébullition de l'alcène est supérieur à 50°C, et
**en ce que** le point d'ébullition de l'alcène est inférieur à 200°C.

2. Solutions selon la revendication 1, **caractérisées en ce que** le semiconducteur organique est un composant pur ou un mélange (une association) de deux composants ou plus, dont au moins l'un présente des propriétés de semiconduction.

3. Solutions selon la revendication 1 ou 2, **caractérisées en ce que** le semiconducteur organique est un composé ou un mélange de composés de poids moléculaire faible, oligomérique, dendritique, linéaire ou ramifié et en particulier polymérique, organique ou organométallique.

4. Solutions selon une ou plusieurs des revendications 1 à 3, **caractérisées en ce qu'**au moins un composant du semiconducteur organique est de poids moléculaire élevé et présente un poids moléculaire M_{w} supérieur à 10.000 g/mol.

5. Solutions selon une ou plusieurs des revendications 1 à 4, **caractérisées en ce que** des semiconducteurs organiques polymériques sont choisis parmi les classes des poly-p-arylènevinylènes (PAVs), poly-fluorènes (PFs), polyspirobifluorènes (PSFs), poly-p-phénylènes (PPPs) ou -biphénylènes, polydihydrophénanthrènes (PDHPs), trans- et cis-polyindénofluorènes (PIFs), polyphénanthrènes, polythiophènes (PTs), polypyridines (PPys), polypyrroles, copolymères comportant des unités structurelles issues de deux ou plus de ces classes, polyvinylcarbazoles (PVKs), polymères triarylamine, polysilylènes, polygermylènes et/ou polymères contenant des unités phosphorescentes, dont tous sont solubles dans des solvants organiques.

6. Solutions selon une ou plusieurs des revendications 1 à 5, **caractérisées en ce que** les solutions comprennent entre 0,01 et 20% en poids du semiconducteur organique ou du mélange correspondant.

7. Solutions selon une ou plusieurs des revendications 1 à 6, **caractérisées en ce que** les solvants utilisés sont des solvants aromatiques mono- ou polysubstitués, des dérivés d'acide formique, des N-alkylpyrrolidones ou des éthers à point d'ébullition élevé et/ou des mélanges avec des alcanes en chaîne droite, ramifiés ou cycliques, des alcools (cyclo)aliphatiques, des éthers, des cétones ou des esters d'acide carboxylique.

8. Solutions selon une ou plusieurs des revendications 1 à 7, **caractérisées ce que** les alcènes contiennent 5 à 15 atomes de carbone.

9. Solutions selon une ou plusieurs des revendications 1 à 8, **caractérisées en ce que** les alcènes sont choisis parmi 2,3-diméthyl-2-butène, 4-méthyl-1-pentène, 2,3-diméthyl-1-butène, 1,5-hexadiène, 1-hexène, 1-méthyl-1-cyclopentène, 1,3-cyclohexadiène, cyclohexène, trans,trans-2,4-hexadiène, 1,4-cyclohexadiène, 2-méthyl-1-hexène, 1-heptène, 2,4,4-triméthyl-1-pentène, 1,7-octadiène, 1-octène, trans-4-octène, trans-2-octène, 1,3-cyclooctadiène, styrène, dicyclopentadiène, 1,9-décadiène, 1-décène, 1-dodécène, cyclododécène, 2,5-diméthyl-2,4-hexadiène, 1-tridécène et cis,trans,trans-1,5,9-cyclododécatriène.

10. Utilisation de solutions selon une ou plusieurs des revendications 1 à 9 pour la fabrication de couches des semiconducteurs organiques sur un substrat.

11. Utilisation de solutions selon la revendication 10 pour la production de couches des semiconducteurs organiques dans des diodes émettrices de lumière organiques ou polymériques (OLEDs, PLEDs), des transistors à effet de champ organiques (O-FETs), des transistors à film mince organiques (O-TFTs), des circuits intégrés organiques (O-ICs), des dispositifs à pincement de champ organiques (O-FQDs), des transistors émetteurs de lumière organiques (O-LETs), des cellules électrochimiques émettrices de lumière (LECs), des cellules solaires organiques (O-SCs), des diodes laser organiques (O-lasers) ou des photorécepteurs organiques (O-PCs).

12. Procédé pour la production de couches semiconductrices organiques sur un substrat, **caractérisé en ce qu'**une solution selon une ou plusieurs des revendications 1 à 9 est traitée au moyen d'un procédé d'impression ou d'un procédé de revêtement en surface.
